# EUROPÄISCHE PATENTANMELDUNG

(11) **EP 0 563 683 A2**
(43) Veröffentlichungstag der Anmeldung: **06.10.1993**
(21) Anmeldenummer: 93104362.4
(22) Anmeldetag: 17.03.1993
(51) Int. Cl.: G01R 27/20, G01R 31/00

(54) **Verfahren und Vorrichtung zur Prüfung von Schaltkontakten**

(30) Priorität: 03.04.1992 DE 4211251
(71) Anmelder: SIEMENS AKTIENGESELLSCHAFT, D-80333 München (DE)
(72) Erfinder: Biehl, Wilfried, W-1000 Berlin 20 (DE); Weiser, Josef, Dr., W-8021 Hohenschäftlarn (DE); Kommoss, Klaus-Dieter, W-1000 Berlin 26 (DE)

(57) **Zusammenfassung**

Bei dem Prüfverfahren wird in drei Stufen ein Prüfstrom angelegt, der in der ersten Stufe maximal bis in die Größenordnung des Nennstromwertes und in der zweiten Stufe maximal bis zu einem Wert in der Größenordnung des zweifachen Nennstromwertes ansteigt und in der dritten Stufe der für den betreffenden Kontakt geltenden Prüfnorm entspricht. In jeder der drei Stufen wird der Spannungsabfall an dem Kontakt gemessen, und es wird ein positives Prüfkriterium abgeleitet, wenn der Spannungsabfall jeweils einen für die betreffende Stufe spezifischen Schwellenwert nicht überschreitet. Dieser Schwellenwert ist abhängig von dem jeweiligen Nennstrom und dem Kontaktdruck und entspricht in der ersten Stufe einer Leistung am geschlossenen Kontakt von nicht mehr als einem Watt, in der zweiten Stufe einer Leistung von nicht mehr als zwei Watt. In der dritten Stufe soll ein anwendungsspezifischer Übergangswiderstand, der in jedem Fall unterhalb von 50 mOhm liegt, nicht überschritten werden.

## Beschreibung

Die Erfindung betrifft ein Verfahren sowie eine Vorrichtung zur Prüfung von Schaltkontakten eines Schaltgerätes, insbesondere eines Relais der Anwendungskategorie III. nach IEC 255-7, CECC 1600.

Bei der Herstellung von Relais und anderen Schaltgeräten läßt es sich nie ganz vermeiden, daß die Kontakte im Fertigungsdurchlauf auf verschiedenartige Weise verschmutzt werden. Dies kann zu Funktionsverschlechterungen oder auch zu Frühausfällen dieser Geräte führen. Um dem zu begegnen, ist es bekannt und üblich, die Kontakte nach dem Fertigungsdurchlauf durch Messung des Kontaktwiderstandes zu prüfen. Dabei werden die gemessenen Kontaktwiderstände mit einem aus der Erfahrung gegebenen Schwellwert verglichen. Liegt der Kontaktwiderstand mehrerer Messungen unterhalb des Schwellwertes, gilt das Relais als gut, im anderen Fall wird es als fehlerhaft ausgeschieden.

Bei den auftretenden Kontaktverunreinigungen muß man allerdings unterscheiden zwischen allgemeinen Verschmutzungen, welche im Montageablauf beispielsweise durch Öl, Staub und allgemein durch leitende oder nichtleitende Partikel entstehen, und Korrosionsbelägen, die durch die Chemie der Umwelt am jeweiligen Fertigungsstandort verursacht werden. Besonders gefährdet sind dabei Kontakte aus Silber und dessen Legierungen, welche mit Luftschadstoffen, wie SO₂, H₂S oder H₂O, reagieren. Derartige Silberkontakte werden beispielsweise bei Starkstromrelais ohne schützenden Goldüberzug eingesetzt. Die Messung des Kontaktwiderstandes bei den üblichen Prüfbedingungen entsprechend der Einsatzbelastung kann normalerweise nicht unterscheiden zwischen Korrosionsbelägen und sonstigen Verschmutzungen.

Bei Schwachstromrelais führt die erwähnte Messung des Kontaktwiderstandes durchaus zu einer zutreffenden Bewertung der Kontaktqualität, da bei niedrigen Strömen sowohl Korrosionsbeläge als auch sonstige Verschmutzungen zu einem frühen Ausfall des Relais führen. Für die Anwendung bei Starkstrombedingungen liegen die Verhältnisse jedoch anders. Hierbei kann der normale vielfältige Schmutz durchaus stören, während beispielsweise die Sulfidierung von Silberkontakten durch den hohen Schaltstrom wegbrennt und damit die Kontaktqualität im Einsatz des Schaltgerätes nicht beeinträchtigt. Die beim späteren Schaltvorgang von Kontakten der genannten Anwendungskategorie auftretenden Leistungen im Schaltlichtbogen sind kurzfristig größer als 1 Watt.

Aufgabe der Erfindung ist es demnach, ein einfaches Prüfverfahren und eine dazu geeignete Vorrichtung zu schaffen, wodurch eine eindeutige Unterscheidung zwischen den beiden beschriebenen Arten der Kontaktverschmutzung ermöglicht wird, so daß eine schnelle Bewertung der Qualität des Schaltgerätes im Sinne der späteren Kontaktanwendung möglich wird.

Erfindungsgemäß wird diese Aufgabe gelöst mit einem Verfahren, welches folgende Schritte enthält:
a) Der Kontakt wird stromlos geschlossen;
b) an dem geschlossenen Kontakt wird in drei aufeinanderfolgenden Stufen ein Prüfstrom angelegt, der in der ersten Stufe bis zu einem ersten Maximalwert ansteigt, der nicht größer als der Nennstromwert des Kontaktes ist,
   der in der zweiten Stufe einen zweiten Maximalwert erreicht, der nicht größer als der zweifache Nennstromwert des Kontaktes ist, und
   der in der dritten Stufe der für den Kontakt geltenden Prüfnorm entspricht;
c) in jeder der drei Stufen wird über den Spannungsabfall der kontaktwiderstand gemessen;
d) ein positives Prüfkriterium wird abgeleitet, wenn in jeder der drei Stufen der Spannungsabfall einen vorgegebenen zugehörigen Schwellenwert nicht übersteigt, wobei gilt:
   - der Schwellenwert für die erste Stufe entspricht einer kurzfristigen Leistung am geschlossenen Kontakt von nicht mehr als einem Watt,
   - der Schwellenwert für die zweite Stufe entspricht einer kurzfristigen Leistung am geschlossenen Kontakt von nicht mehr als zwei Watt und
   - der Schwellenwert in der dritten Stufe wird nach anwendungsspezifischen Gesichtspunkten gewählt und entspricht in jedem Fall einem Übergangswiderstand von weniger als 50 mOhm.

Bei einer bevorzugten Ausgestaltung des Verfahrens läßt man den angelegten Strom als Gleichstrom in der ersten Stufe kontinuierlich ansteigen, während er in der zweiten und in der dritten Stufe jeweils sprungartig angehoben bzw. abgesenkt wird. Es wäre aber auch möglich, den Prüfstrom über alle drei Stufen kontinuierlich anzuheben bzw. abzusenken.

Wie oben ausgeführt, werden die Schwellenwerte in den ersten beiden Prüfschritten so gewählt, daß unter Berücksichtigung des jeweiligen Nennstroms und des zugehörigen Kontaktdrucks bestimmte Leistungswerte nicht überschritten werden. Dabei wird vorausgesetzt, daß bei dem entsprechenden Prüfstrom reine Korrosionsbeläge durchgebrannt werden. Beispielsweise beträgt für übliche Relais mit Starkstromkontakten der Prüfstrom in der ersten Stufe etwa 5 A, in der zweiten Stufe etwa 10 A und in der dritten Stufe normgemäß 1 A. Als Schwellenwert kann dann beispielsweise für die erste Stufe ein Wert von 200 mV gelten, während in der zweiten Stufe je nach dem Nennstromwert ein Schwellenwert festgelegt wird, der bei relativ geringen Nennströmen ebenfalls bei 200 mV liegen kann, für höhere Nennströme (über 20 A) und entsprechend höhere Kontaktkräfte (über 30 cN) bei 100, 10 oder gar 1 mV liegen kann. Für die dritte Stufe gelten die anwendungsspezifischen Norm-Prüfbedingungen, wobei als Schwellenwert für den Kontaktwiderstand beispielsweise 20 mOhm, vorzugsweise jedoch niedrigere Werte, etwa bei 5 mOhm, vorgesehen werden. Zur Erzeugung des Prüfstroms kann beispielsweise eine Spannungsquelle mit einer EMK von 12 V oder 24 V verwendet werden. Bei der praktischen Durchführung der Prüfung wird für einen Prüfdurchlauf üblicherweise eine Zeit von unter 1 s, beispielsweise 500 ms, benötigt.

Eine Prüfvorrichtung zur Durchführung des erfindungsgemäßen Verfahrens weist vorzugsweise auf:
- Eine Anschalteinrichtung für mindestens ein Schaltgerät,
- eine Stromquelle zum Anlegen eines veränderbaren Prüfstroms an die Kontakte des Schaltgerätes,
- eine Spannungs-Meßvorrichtung zum Abgreifen des Spannungsabfalls an den Kontakten des Schaltgerätes,
- eine Vergleichseinrichtung zum Vergleich des gemessenen Spannungsabfalls mit verschiedenen Schwellenwerten in Abhängigkeit vom Prüfstrom und
- eine Steuereinrichtung zur Einstellung des Prüfstroms und der zugehörigen Schwellenwerte.
Dabei kann der Prüfablauf natürlich durch eine entsprechend programmierte Datenverarbeitungsanlage gesteuert werden.

Die Erfindung wird nachfolgend anhand der Zeichnung näher erläutert. Es zeigt
Figur 1 den grundsätzlichen Aufbau einer für die Erfindung geeigneten Vorrichtung in einem Blockschaltbild,
Figur 2 in einem Diagramm den typischen Verlauf von Strom und Spannung bei der Durchführung des erfindungsgemäßen Prüfverfahrens.

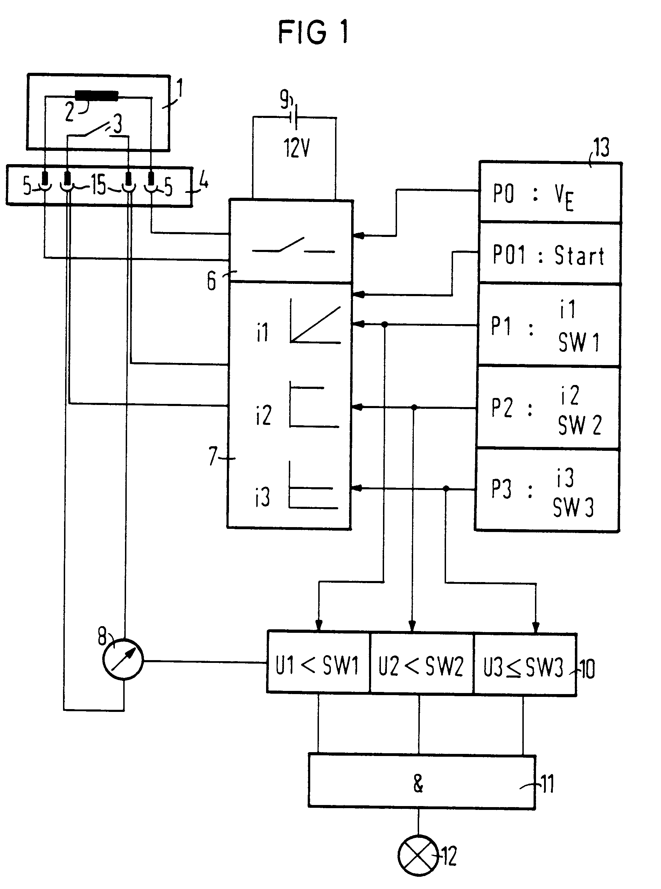

In Figur 1 ist ein Prüfling in Form eines Relais 1 schematisch gezeigt, der in einem Gehäuse eine Erregerspule 2 sowie Kontaktpaare 3 (nur eines gezeigt) aufweist. Das zu prüfende Relais 1 wird auf eine Anschalteinrichtung 4 gesteckt, welche Aufnahmebuchsen 5 für die Anschlüsse der Erregerspule 2 sowie Aufnahmebuchsen 16 für die Kontaktanschlüsse aufweist. Die Aufnahmebuchsen 5 sind an eine Schaltvorrichtung 6 angeschaltet, während die Anschlußbuchsen 6 der Kontaktelemente mit einem Stromregler 7 und parallel dazu in Vierpol-Anschaltung mit einer Spannungs-Meßvorrichtung 8 verbunden sind. Die Schalteinrichtung 6 und der Stromregler 7 werden von einer Stromquelle 9 mit einer EMK von beispielsweise 12 V versorgt. Das Ausgangssignal der Spannungs-Meßvorrichtung wird einer Vergleichseinrichtung 10 zugeführt, wo es je nach der gerade anstehenden Prüfstufe mit einem von verschiedenen Schwellenwertes SW1, SW2 und SW3 verglichen wird. Die Ergebnisse der verschiedenen Vergleiche werden aus der Vergleichseinrichtung 10 über eine UND-Verknüpfung 11 einer Anzeigevorrichtung 12 zugeführt.

Die Schaltvorrichtung 6 sowie der Regler 7 und die Vergleichseinrichtung 10 werden über eine Ablaufsteuerung 13 in fest vorgegebenen Prüfschritten P0 bis P3 aktiviert. Zu Beginn des Prüfvorgangs, also nach dem Einstecken des Prüflings, wird in dem ersten Schritt P0 eine Erregerspannung U_{E} über die Schaltvorrichtung 6 an die Erregerspule 2 des zu prüfenden Relais angelegt; d. h., das Relais wird trocken geschaltet. Dies gilt natürlich nur für Schließerkontakte; bei Öffnerkontakten erübrigt sich die Erregung des Relais.

Sind die Kontakte geschlossen, so wird in dem Schritt P01 der Regler 7 freigegeben, also die eigentliche Prüfung gestartet. In der nun folgenden ersten Prüfstufe P1 wird über den Regler 7 ein erster Prüfstrom i1 über die Buchsen 6 an das Kontaktpaar 3 angelegt, zugleich wird in der Vergleichseinrichtung 10 der Schwellenwert SW1 vorgegeben. Über die Spannungs- Meßvorrichtung 8 wird nun ein erster Spannungsabfall U1 gemessen und in der Vergleichseinrichtung 10 mit dem Schwellenwert SW1 verglichen. Bleibt U1 unter dem Schwellenwert SW1, wird ein erstes Signal an die UND-Verknüpfung 11 abgegeben (und gegebenenfalls gespeichert).

In einer zweiten Prüfstufe P2 wird dann von der Ablaufsteuerung 13 über den Regler 7 ein zweiter Prüfstrom i2 an die Kontakte 3 angelegt. Wiederum wird über die Spannungs-Meßvorrichtung 8 ein Spannungsabfall, nunmehr U2, gemessen und mit dem jetzt aktivierten Schwellenwert SW2 verglichen. Bleibt U2 unterhalb des Schwellenwertes SW2, wird ein zweites Signal an die UND-Verknüpfung 11 gegeben und gegebenenfalls gespeichert.

In einer dritten Prüfstufe P3 wird dann ein dritter Prüfstrom i3 an die Kontakte angelegt. Der über die Spannungs-Meßvorrichtung 8 gemessene dritte Spannungsabfall U3 wird in der vorher genannten Weise in der Vergleichseinrichtung 10 mit einem Schwellenwert SW3 verglichen. In diesem Fall wird ein Gut- Signal an die UND-Verknüpfung 11 gegeben, wenn U3 den Schwellenwert SW3 nicht übersteigt. Wurde die Prüfbedingung in allen drei Fällen bestanden, so wird über die UND-Verknüpfung 11 ein Gut-Signal an die Anzeigeeinrichtung 12 gegeben oder auch in anderer Weise ausgewertet.

Für die Prüfung von Starkstromkontakten aus Silber oder Silberlegierung wird beispielsweise in dem ersten Prüfschritt ein Prüfstrom von i1 zwischen 0 und 5 A gewählt, wobei der Spannungsabfall am Kontakt einen Schwellenwert SW1 von 200 mV nicht übersteigen darf. Der Prüfstrom i2 im zweiten Prüfschritt beträgt bei einer typischen Ausführungsform 10 A, wobei der Spannungsabfall am Kontakt höchstens 10 bis 100 mV je nach Kontaktkraft des Relais betragen darf. Im Prüfschritt P3 wird typischerweise ein Prüfstrom i3 von 1 A verwendet. Der Schwellenwert SW3 für den zulässigen Kontaktwiderstand wird in diesem Prüfschritt gemäß der jeweils anzuwendenden Kundenspezifikation gewählt.

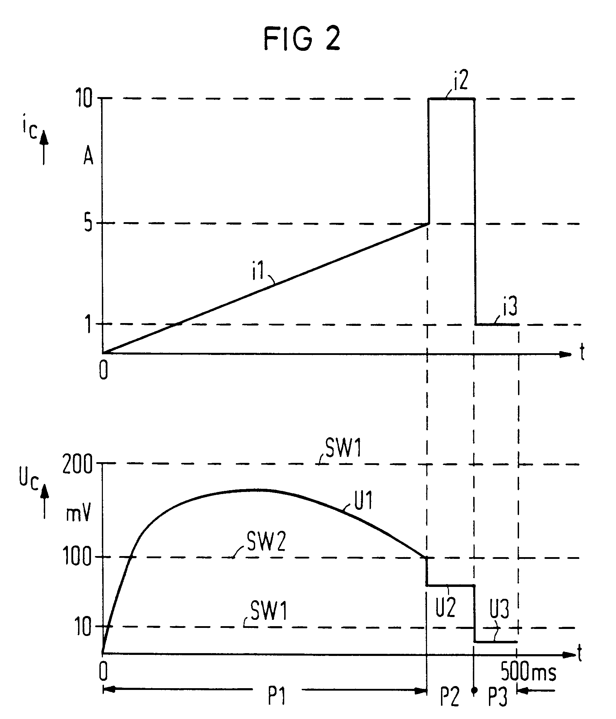

In Figur 2 sind beispielhaft in einem Diagramm der Verlauf des Prüfstroms i_{C} und der entsprechende Verlauf des Spannungsabfalls U_{C} über der Zeit t aufgetragen. Dabei wird angenommen, daß alle drei Prüfstufen P1 bis P3 zusammen eine Zeit von 500 ms benötigen, wobei die erste Stufe P1 den größten Teil davon einnimmt. Wie aus Figur 2 ersichtlich ist, wird in der ersten Prüfstufe P1 der Prüfstrom i_{C} kontinuierlich von 0 bis auf 5 A erhöht. Der Spannungsabfall U1 steigt dabei zunächst steil an, bleibt jedoch unter der hier vorgesehenen Schwelle SW1 von 200 mV und verringert sich nach dem Durchbrennen des Korrosionsbelages sogar wieder.

In der zweiten Prüfstufe P2 wird ein Prüfstrom i2 von 10 A angelegt. Da die Korrosionsschicht durchgebrannt ist, verringert sich nunmehr der Spannungsabfall U2 auf einen Wert unterhalb der zweiten Schwelle SW2 von 100 mV. In der dritten Stufe P3 schließlich wird gemäß einer Norm, beispielsweise IEC 255-7, CECC 16000, ein Prüfstrom i3 von 1 A angelegt. Da nunmehr die Korrosionsschicht beseitigt ist, bleibt auch der Spannungsabfall U3 unter dem Schwellenwert SW3, der hier anwendungsorientiert beispielsweise bei etwa 10 mV, entsprechend einem Übergangswiderstand von 10 mOhm, festgelegt wurde. Da somit in allen drei Stufen P1 bis P3 der Spannungsabfall unter dem jeweiligen Schwellenwert SW1 bis SW3 geblieben ist, kann ein Relais mit diesem Kontakt als geeignet für die Anwendung bewertet werden, obwohl am Anfang des Prüfablaufes, bedingt durch Korrosionsbeläge, ein hoher Kontaktwiderstand festgestellt wurde.

Bei dem Prüfbeispiel von Figur 2 wurden Werte vorgesehen, die für Kontakte aus Silber oder Silberlegierungen für Anwendungen unterhalb von 20 A Schaltstrom gelten. Bei höheren Nennschaltströmen könnte beispielsweise für die zweite Stufe eine Schwelle von 50 mV und für die dritte Stufe eine Schwelle entsprechend 5 mOhm gewählt werden, für Nennschaltströme über 50 A sollten diese Schwellen noch weiter gesenkt werden, beispielsweise in der zweiten Stufe auf 10 mV und in der dritten Stufe auf einen Wert entsprechend 1 mOhm. Alle diese Werte sind jedoch nur Beispielsangaben. Für die Anwendung des Verfahrens können vom Fachmann jeweils in Anpassung an die verwendeten Materialien, den Nennschaltstrom und den zugehörigen Kontaktdruck die geeigneten Schwellenwerte ermittelt werden. Kontakte, die den Prüfbedingungen in dem beschriebenen Ablauf genügen, können möglicherweise sulfidiert sein und damit zunächst einen relativ hohen Kontaktwiderstand aufweisen. Durch die Prüfbedingung wird aber sichergestellt, daß diese Kontakte nicht anderweitig verschmutzt sind und somit für die Starkstromanwendung geeignet bleiben.

## Patentansprüche

1. Verfahren zur Prüfung von Schaltkontakten mit folgenden Schritten:
a) der Kontakt (3) wird stromlos geschlossen;
b) an den geschlossenen Kontakt wird in drei aufeinanderfolgenden Stufen (P1, P2, P3) ein Prüfstrom (i1, i2, i3) angelegt, wobei der Prüfstrom in der ersten Stufe (P1; i1) bis zu einem ersten Maximalwert ansteigt, der nicht größer als der Nennstromwert des Kontaktes ist, der in der zweiten Stufe (P2) einen zweiten Maximalwert erreicht, der nicht größer als der zweifache Nennstromwert des Kontaktes ist, und
der in der dritten Stufe (P3) der für den Kontakt geltenden Prüfnorm entspricht;
c) in jeder der drei Stufen (P1, P2, P3) wird über den Spannungsabfall (U1, U2, U3) der Kontaktwiderstand gemessen;
d) ein positives Prüfkriterium wird abgeleitet, wenn in jeder der drei Stufen der Spannungsabfall einen vorgegebenen zugehörigen Schwellenwert (SW1, SW2, SW3) nicht übersteigt, wobei gilt:
- der Schwellenwert für die erste Stufe (SW1) entspricht einer Leistung am geschlossenen Kontakt von nicht mehr als ein Watt,
- der Schwellenwert für die zweite Stufe (SW2) entspricht einer Leistung am geschlossenen Kontakt von nicht mehr als zwei Watt und
- der Schwellenwert in der dritten Stufe (SW3) wird nach anwendungsspezifischen Gesichtspunkten gewählt und entspricht in jedem Fall einem Übergangswiderstand von weniger als 50 mOhm.

2. Verfahren nach Anspruch 1, **dadurch gekennzeichnet,** daß der angelegte Strom als Gleichstrom in der ersten Stufe kontinuierlich ansteigt, in der zweiten und dritten Stufe sprungartig angehoben bzw. abgesenkt wird.

3. Verfahren nach Anspruch 1, **dadurch gekennzeichnet,** daß der Prüfstrom über alle drei Stufen kontinuierlich angehoben bzw. abgesenkt wird.

4. Verfahren nach einem der Ansprüche 1 bis 3, **dadurch gekennzeichnet,** daß für die Prüfung eines Relais mit Starkstromkontakten aus Silber oder einer Silberlegierung in der ersten Stufe ein Prüfstrom von etwa 5 A, in der zweiten Stufe ein Prüfstrom von etwa 10 A sowie in der dritten Stufe ein Prüfstrom von etwa 1 A angelegt wird, wobei als Schwellenwerte für den Spannungsabfall am Kontakt in der ersten Stufe ca. 200 mV und in der zweiten Stufe ein Wert zwischen 200 mV und 10 mV, je nach Kontaktkraft vorgesehen sind.

5. Verfahren nach Anspruch 4, **dadurch gekennzeichnet,** daß der Prüfstrom mit einer Spannungsquelle erzeugt wird, deren EMK bei 12 V liegt.

6. Verfahren nach einem der Ansprüche 1 bis 5, **dadurch gekennzeichnet,** daß die Prüfung in einer Zeit weniger als 1 s, vorzugsweise von etwa 500 ms, durchgeführt wird.

7. Prüfvorrichtung zur Durchführung des Verfahrens nach einem der Ansprüche 1 bis 6, welche aufweist:
- eine Anschalteinrichtung (4) für mindestens ein Schaltgerät (1),
- eine Stromquelle (9) zum Anlegen eines veränderbaren Prüfstroms (i1, i2, i3) an die Kontakte des Schaltgerätes,
- eine Spannungs-Meßvorrichtung (8) zum Abgreifen des Spannugsabfalls an den Kontakten des Schaltgerätes,
- eine Vergleichseinrichtung (10) zum Vergleich des gemessenen Spannungsabfalls mit verschiedenen Schwellenwerten (SW1, SW2, SW3) in Abhängigkeit vom Prüfstrom und
- eine Steuereinrichtung (13) zur Einstellung des Prüfstroms und der zugehörigen Schwellenwerte.
